# EUROPEAN PATENT SPECIFICATION

(11) **EP 3 364 730 B1**
(45) Date of publication and mention of the grant of the patent: **21.10.2020**
(21) Application number: 16908356.5
(22) Date of filing: 05.12.2016
(51) Int. Cl.: H05K 1/02, H05K 3/00, H05K 3/28, H05K 3/12

(54) **METHOD FOR MANUFACTURING PRINTED WIRING BOARD**
VERFAHREN ZUR HERSTELLUNG EINER LEITERPLATTE
PROCÉDÉ DE FABRICATION D'UN CIRCUIT IMPRIMÉ

(43) Date of publication of application: 22.08.2018
(73) Proprietor: MITSUBISHI ELECTRIC CORPORATION, Chiyoda-ku Tokyo 100-8310 (JP)
(72) Inventor: MIURA, Tsuyoshi, Tokyo 100-8310 (JP); KOJIMA, Tomotaka, Tokyo 100-8310 (JP)
(74) Representative: Pfenning, Meinig & Partner mbB
(86) International application number: PCT/JP2016/086041
(87) International publication number: WO 2018/105000

(56) References cited:
- JP-A- H0 537 141
- JP-A- H0 715 118
- JP-A- H0 715 118
- JP-A- 2002 232 124
- JP-A- 2006 319 031
- JP-A- 2006 319 031
- JP-A- 2014 107 452
- JP-A- 2016 129 181
- JP-B1- 5 973 689
- JP-B2- 3 070 648
- KR-A- 20120 033 840
- US-A1- 2003 000 083
- US-A1- 2008 153 041
- US-A1- 2010 000 087
- US-A1- 2016 011 514

## Description

### Field

The present invention relates to a method of manufacturing a printed wiring board.

### Background

Conventionally, when a printed wiring board is manufactured, characters are printed on the printed wiring board by forming a copper foil pattern on a base material, applying and forming a solder resist on the copper foil pattern by printing, and forming a pattern of a character printing layer on the solder resist. However, when the solder resist is applied and formed on the copper foil pattern by printing, shoulders are angulated at the corners of the copper foil pattern, and the solder resist becomes thin or the copper foil pattern is exposed. This may cause corrosion of the copper foil pattern on the printed wiring board. On the other hand, another method of manufacturing the printed wiring board can be considered. In the method, the characters are printed on the printed wiring board by applying and forming the solder resist on the copper foil pattern by printing and forming the pattern of the character printing layer on the solder resist and a corrosion coating layer is applied and formed on the entire surface with a coating agent after components have been mounted.

Patent Literature 1 which is an example of prior art discloses a technique for preventing the corrosion of 2 the copper foil pattern by printing the character after the solder resists are applied and formed on the copper foil pattern twice.

Patent Literature 2 discloses a method of forming solder resist of a circuit substrate. The photo solder resist being formed on the copper foil pattern covers the entire surface of the copper foil pattern and a light-shielding ink is formed on the photo solder resist.

Patent Literature 3 describes a method of manufacturing a printed board in which a protective layer is formed on all the surface of an insulating board so as to cover the insulating board and a conductor pattern excluding an area used for characters and an area used as connecting pad.

In Patent Literature 4 solder resists for different sensitivities are disclosed.

Patent Literature 5 discloses a method of forming a printed wiring board comprising the steps of coating a photocurable solder resist on a substrate and precuring this layer, printing sign indications on the solder resist layer and precuring these sign indications, exposing the solder resist layer and the sign indications to UV radiation through a mask and removing the non-exposed regions, and postcuring the solder resist layer and the sign indications.

### Citation List

### Patent Literature

Patent Literature 1: Japanese Patent Application Laid-Open No. H4-314384
Patent Literature 2: JP H05-37141 A
Patent Literature 3: JP 2006 319031 A
Patent Literature 4: JP H07-15118 A
Patent Literature 5: KR 2012/0033840 A

### Summary

### Technical Problem

However, according to the above conventional technique, it is necessary to apply and form the corrosion coating layer on the entire surface or apply and form the solder resists for a plurality of times, and the manufacturing process becomes complicated. Therefore, there has been a problem in that it has been difficult to effectively prevent the corrosion of the copper foil pattern.

The present invention has been made in view of the above, and a purpose of the present invention is to obtain a printed wiring board in which corrosion of a copper foil pattern is effectively prevented.

### Solution to Problem

In order to solve the aforementioned problem and achieve the object, a method of manufacturing a printed wiring board according to the present invention includes the steps of claim 1.

### Advantageous Effects of Invention

The method of manufacturing a printed wiring board according to the present invention has an effect such that corrosion of a copper foil pattern is effectively prevented.

### Brief Description of Drawings

FIG. 1 is a top view illustrating details of a printed wiring board according to an embodiment.
FIG. 2 is an enlarged top view illustrating an encircled portion illustrated in FIG. 1.
FIG. 3 is a cross-sectional view illustrating a cross section.
FIG. 4 is a cross-sectional view of a comparative example corresponding to FIG. 3.
FIG. 5 is a flowchart illustrating an exemplary manufacturing process of the printed wiring board according to the embodiment.
FIG. 6 is a top view illustrating a pattern of the printed wiring board according to the embodiment.
FIG. 7 is a top view illustrating a copper foil pattern according to the embodiment.
FIG. 8 is a top view illustrating a pattern of a solder resist according to the embodiment.
FIG. 9 is a top view illustrating a pattern of a character layer in the comparative example.
FIG. 10 is a top view illustrating a pattern of an outline character forming layer according to the embodiment.
FIG. 11 is a schematic top view illustrating an outdoor unit of an air conditioner in which the printed wiring board according to the embodiment has been arranged.
FIG. 12 is a schematic front view illustrating the outdoor unit of the air conditioner in which the printed wiring board according to the embodiment has been arranged.

### Description of Embodiments

Hereinafter, a printed wiring board, an air conditioner, and a method of manufacturing a printed wiring board according to an embodiment of the present invention will be described in detail with reference to the drawings. The present invention is not limited to the embodiment.

### Embodiment.

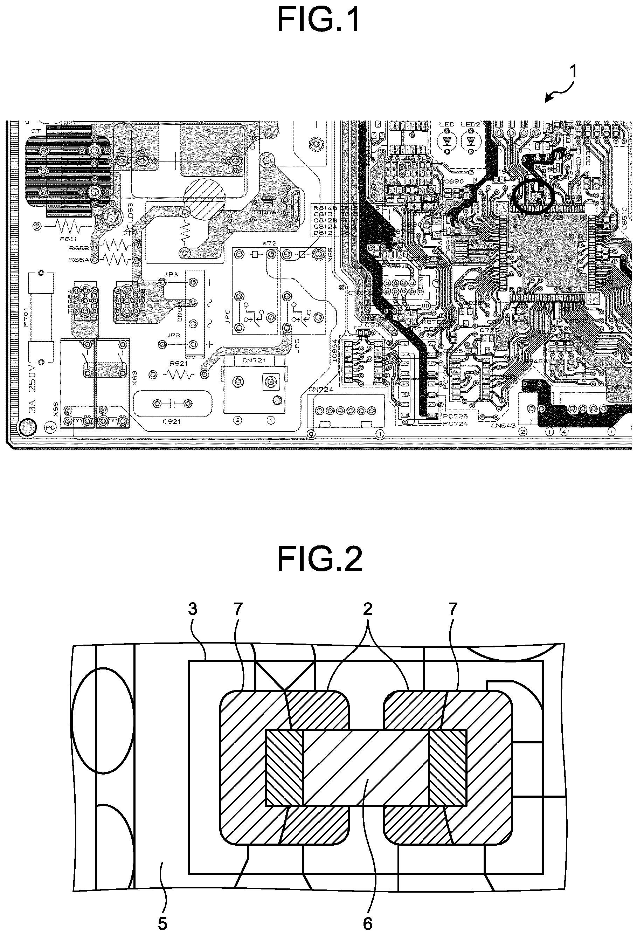

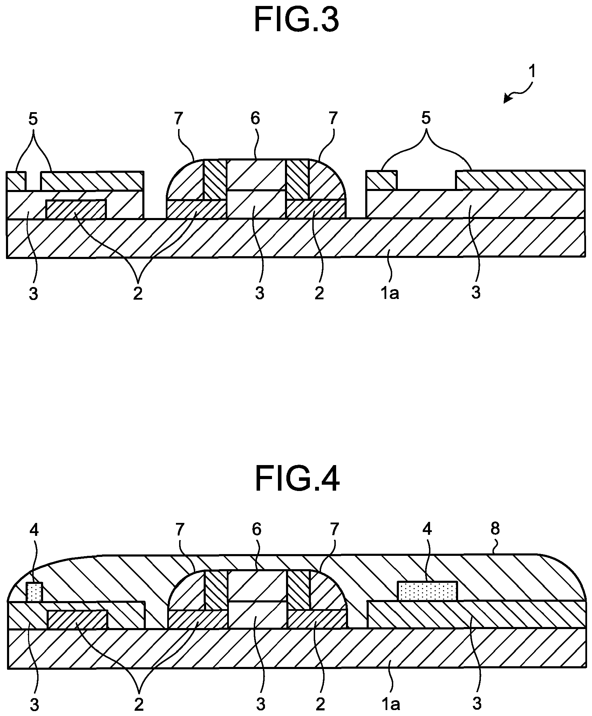

FIG. 1 is a top view illustrating details of a printed wiring board 1 according to the present embodiment. FIG. 2 is an enlarged top view of an encircled portion illustrated in FIG. 1. FIG. 3 is a cross-sectional view illustrating a cross section. FIG. 4 is a cross-sectional view of a comparative example corresponding to FIG. 3.

On the printed wiring board 1 illustrated in FIG. 1, a solder resist 3 is applied and formed on a copper foil pattern 2 provided on a base material 1a by a spraying method with a white ink, and an outline character forming layer 5 of the solder resist 3 is applied and formed with a green ink by printing. Therefore, the appearance of the formed characters is white, and a part where no character has been formed is green. The appearance similar to that in a case where the solder resist of the printed wiring board is applied and formed with the green ink by printing and the characters are applied and formed with the white ink by printing as conventional can be obtained. Consequently, it is possible to perform an operation for visually confirming a soldering condition used in a conventional manufacturing process as conventional, and a conventional color identification program of an appearance inspection device can be used without any change. Therefore, it is possible to apply the printed wiring board 1 to the conventional manufacturing process while the changes to the conventional manufacturing process is suppressed as much as possible.

Furthermore, on the printed wiring board 1 illustrated in FIG. 1, the solder resist 3 covers the copper foil pattern 2. Therefore, it is not necessary to provide a coating layer 8 applied and formed to cover the entire surface as in the comparative example illustrated in FIG. 4 or it is possible to reduce a forming area of the coating layer 8 than the comparative example. Therefore, an applying and forming time of the coating layer 8 is reduced, a time required for a production process can be shortened, and productivity can be improved.

In the printed wiring board 1 illustrated in FIG. 1, it is not necessary to provide the coating layer 8 applied and formed to cover the entire surface as described above or it is possible to reduce the forming area of the coating layer 8. Therefore, at the time of designing the copper foil pattern 2 on the printed wiring board 1, restriction caused by a coating device nozzle which is considerable when the coating layer 8 is applied and formed is eliminated or reduced, and a degree of freedom in designing of the copper foil pattern 2 is increased.

Conventionally, the coating layer 8 has been formed of a coating agent after components have been mounted to prevent corrosion. The conventional coating agent has high viscosity and, the thickness of the applied coating agent cannot be made to be uniform. When the coating agent has been applied to the printed wiring board before the components have been mounted, the surface of the printed wiring board has become uneven, and the coating agent has dripped off. Therefore, it has been difficult to mount the components after the conventional coating agent has been applied. Therefore, the coating agent has been applied after the components have been mounted. However, there are some components to which the coating agent can be applied and some components to which the coating agent cannot be applied. It has been necessary to apply the coating agent as avoiding the components that should not be coated with the coating agent. A connector can be exemplified as the component that should not be coated with the coating agent. The application of the coating agent to the connector causes a contact failure. In the device for applying the coating agent, since an operation of a coating nozzle is restricted in the vertical direction and the horizontal direction, it is necessary to separately arrange components to which the coating agent can be applied and components to which the coating agent cannot be applied according to the movement of the nozzle. However, according to the present embodiment, since the corrosion countermeasure has been already applied to the entire printed wiring board before the components are mounted, the restriction in the arrangement of the component is not required. Therefore, the degree of freedom in designing of the copper foil pattern 2 is increased. Although the width of the copper foil pattern at a place where the coating nozzle cannot reach has been conventionally widened to prevent the corrosion, such a restriction is no more required according to the present embodiment. Therefore, the degree of freedom in designing of the copper foil pattern 2 is greatly increased.

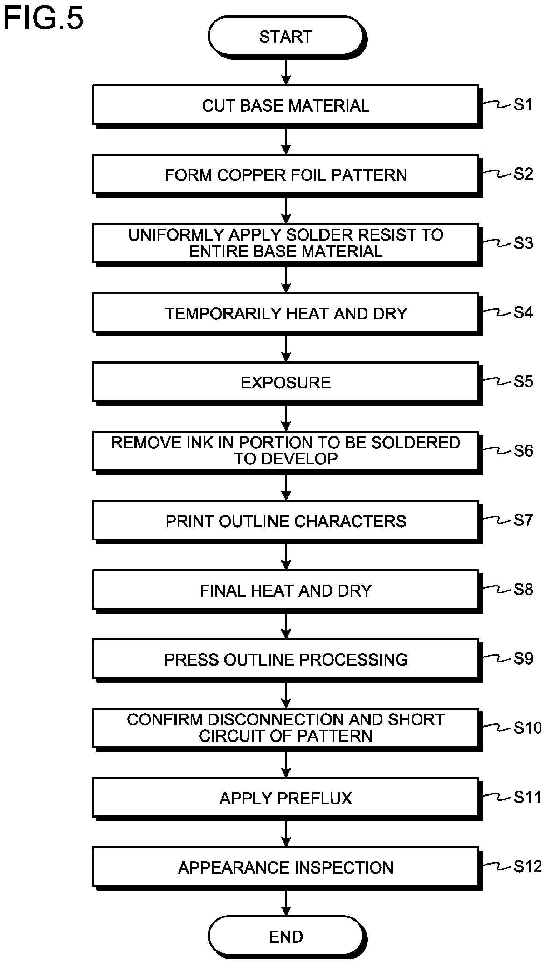

Next, an exemplary manufacturing process of the printed wiring board 1 according to the present embodiment will be described. FIG. 5 is a flowchart illustrating an exemplary manufacturing process of the printed wiring board 1 according to the present embodiment. First, the processing starts and a base material is cut (S1) to obtain a base material 1a on which the printed wiring board 1 is formed. Here, the base material 1a is cut into an appropriate size that can be processed in a factory facility. As the base material 1a, a base material can be exemplified the copper foil has been attached on the entire surface of the base material in which an epoxy resin has been penetrated into a paper phenol material or a glass cloth.

Next, the copper foil pattern 2 is formed by removing the copper foil other than a part necessary for forming a circuit by the copper foil pattern, that is, a part of the copper foil by dissolving it with a solvent (S2). Here, CuCl₂, that is, cupric chloride can be exemplified as the solvent for dissolving and removing a part of the copper foil. However, the solvent is not limited to cupric chloride.

The copper foil pattern 2 is formed by attaching a laminated dry film including a photosensitive component to the copper foil and then performing exposure by laminating an exposure film for forming the copper foil pattern 2 on the laminated dry film. In the exposure film, there are a black portion which shields light and a transparent portion which transmits light. In the portion overlapped with the transparent portion, ultraviolet rays are irradiated at the time of the exposure, and the photosensitive component of the laminated dry film reacts to the ultraviolet rays. In the portion overlapped with the black portion, the photosensitive component does not react to the ultraviolet rays, and the laminated dry film is removed at the time of development in the subsequent process. By performing the development processing after the exposure, the laminated film remains on the exposed portion, and the laminated film at the other portion is removed. Subsequently, by making the base material 1a pass through a tank of acid cupric chloride, the copper foil on the portion overlapping with the portion where the laminated dry film has been removed is removed, and the portion of the copper foil where the laminated dry film exists is protected to remain. Subsequently, the base material 1a passes through an alkali caustic soda tank to remove the remaining laminated film. However, the method of forming the copper foil pattern 2 is not limited thereto, and the copper foil pattern 2 may be formed by a printing method or other photographic method.

Next, the solder resist 3 is uniformly applied to the entire base material 1a (S3). Here, the solder resist 3 is applied by a spray method. The solder resist 3 can protect a part of the copper foil pattern 2 to be formed later which should be prevented from having contact with the solder, protect the copper foil pattern 2 from other foreign matters such as dusts, prevent oxidation corrosion of the copper foil pattern 2, and improve insulation properties.

Next, the base material 1a on which the solder resist 3 has been formed is temporarily heated and dried (S4). As described above, the portion to be soldered is exposed and developed in a later process to remove the solder resist 3. The exposure is performed by laminating the exposure film and irradiating the laminated film with ultraviolet rays. In this process, to laminate the exposure film, it is necessary to cure the ink. This is because in a case where the ink is not cured, the ink of the solder resist 3 adheres to the exposure film. Therefore, here, a heating and drying process for curing the ink of the solder resist 3 so that the ink of the solder resist 3 is not attached to the exposure film is referred to as temporary heating and drying. However, when the ink of the solder resist 3 is excessively cured, unnecessary solder resist 3 cannot be removed by the development in the subsequent process. Therefore, the ink is dried to be in a semi-cured state.

Then, the exposure is performed to form a pattern of the solder resist 3 on the temporarily heated and dried base material 1a (S5). That is, as described above, the exposure is performed by laminating the exposure film on the temporarily heated and dried base material 1a and irradiating the laminated film with ultraviolet rays. The exposure film has a black portion and a transparent portion. Since the black portion shields light, the semi-cured ink of the solder resist 3 overlapping with the black portion is not exposed. The semi-cured ink of the solder resist 3 overlapping with the transparent portion is exposed, and the photosensitive component included in the ink of the solder resist 3 is reacted. Although the portion in which the photosensitive component has reacted is fixed to and remains on the base material 1a as the solder resist 3, a portion overlapping with the black portion in which the photosensitive component is not reacted is removed by the development in the subsequent process. Then, the copper foil pattern 2 is exposed and becomes a solderable part.

Next, the semi-cured ink of the solder resist 3 in a portion necessary for development and soldering is removed from the exposed base material 1a (S6).

Next, outline characters are printed on the base material 1a from which the semi-cured ink of the solder resist 3 on the portion to be soldered has been removed (S7). Then, final heating and drying is performed (S8), and press outline processing is performed (S9). At the time of the outline character printing in S7, the outline characters are formed by printing with a character printing ink. The outline character formed here includes a number to be used for verifying parts and circuit diagrams, various standard numbers, and characters required for development tests, manufacture and service. In the final heating and drying in S8, the semi-cured ink of the solder resist 3 and the character printing ink are cured. The final heating and drying is performed at a temperature higher than the temporary heating and drying. Then, in the press outline processing in S9, the base material 1a is molded by press working to have a size suitable for incorporation into a product by using a metal mold. As a result, printing margins and alignment marks used for printing by a printing machine are removed. Furthermore, to improve the production efficiency, in a case where a plurality of printed wiring boards 1 is printed at a time, that is, in a case where the base material 1a is processed into the plurality of printed wiring boards 1, the base material 1a is cut into pieces by the press outline processing in S9.

Next, electrical disconnection and short circuit of the pattern are confirmed by conducting an electrical inspection on the base material 1a after the press outline processing has been performed (S10). That is, whether the short circuit and the electrical disconnection occur in the copper foil pattern 2 is confirmed by the electrical inspection performed by applying a pin relative to the base material 1a which has processed into the size which can be incorporated into the product.

Next, preflux is applied (S11) to prevent oxidation of the copper foil pattern 2 and to secure solderability of solder 7. That is, after the electrical inspection, the preflux is attached on the surface of the copper foil pattern 2 so that the solder is smoothly wet at the time of soldering while the oxidation of the exposed portion of the copper foil pattern 2 is prevented.

Finally, an appearance is inspected (S12), and the processing is terminated. In the appearance inspection in S12, scratches or cracks on the surface of the printed wiring board 1 are confirmed.

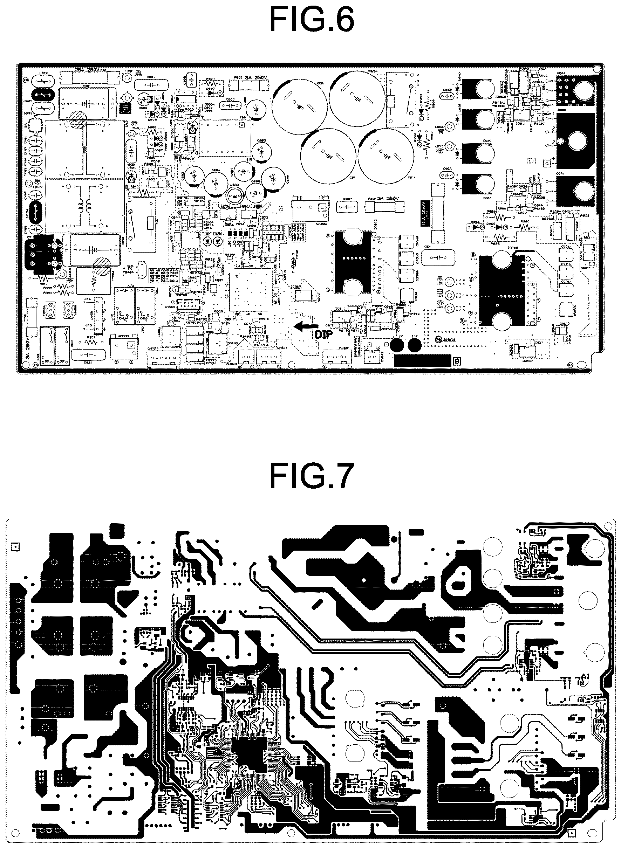

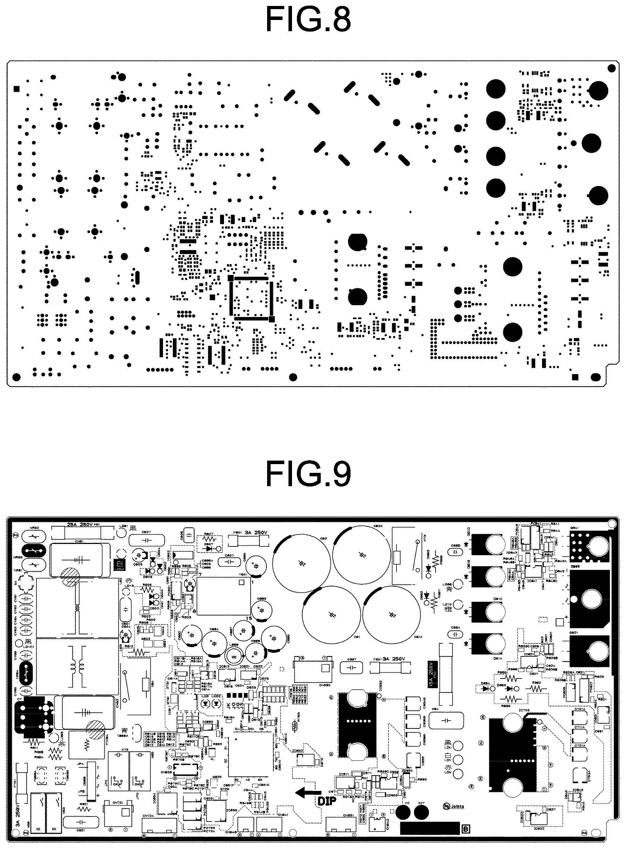

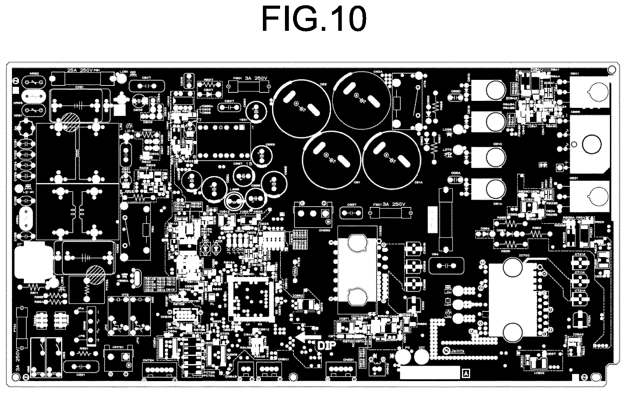

FIG. 6 is a top view illustrating the pattern of the printed wiring board 1 according to the present embodiment. FIG. 7 is a top view illustrating the copper foil pattern 2 according to the present embodiment. FIG. 8 is a top view illustrating the pattern of the solder resist 3 according to the present embodiment. FIG. 9 is a top view illustrating a pattern of a character layer 4 in the comparative example. FIG. 10 is a top view illustrating a pattern of the outline character forming layer 5 according to the present embodiment. In FIGS. 7 to 10, the top views of the patterns formed on the printed wiring board 1 are respectively illustrated.

The copper foil pattern 2 is formed on the printed wiring board 1. The solder resist 3 is uniformly formed on the copper foil pattern 2 to cover the copper foil pattern 2. Here, as a method of uniformly forming the solder resist 3, application of the solder resist 3 by the spray method can be exemplified.

In addition, the outline character forming layer 5 is formed and the outline characters are formed on the solder resist 3, and most part of the copper foil pattern 2 is covered with the solder resist 3 and the outline character forming layer 5. The copper foil pattern 2 is protected by two layers.

Also, on the surface of the printed wiring board 1, a surface mounting component 6 and discrete components to be automatically mounted and a manual insertion part (not illustrated) are disposed, and these parts are fixed by the solder 7 as described later. The surface mounting component 6 is a mount-type automatic mounting component of which an electrode has a planar shape, and a chip component resistance, a chip component capacitor, and a chip component diode can be exemplified as the surface mounting component 6. The discrete component is an automatic mounting component to be inserted into a lead-type component hole, and a discrete resistor, a discrete capacitor, and a discrete diode can be exemplified as the discrete component. A large capacity resistor, a hybrid IC, a transformer, a coil, a large capacity semiconductor, and a large capacitor can be exemplified as the manual insertion part.

The main feature of the printed wiring board 1 is that the solder resist 3 and the outline character forming layer 5 are formed. The solder resist 3 is formed by being uniformly applied on the copper foil pattern 2 by the spray method. The outline character forming layer 5 is applied on the solder resist 3 by a printing method with the outline characters. The portion where the outline character forming layer 5 has been formed is a portion on which the characters are not formed, and the portion where the outline character forming layer 5 has not been formed is a portion on which the characters are formed. It is preferable that the solder resist 3 be a white layer coated and formed by the spray method with the white ink and the outline character forming layer 5 be a green layer coated and formed by printing with the green ink.

As described above, by forming and uniformly applying the solder resist 3 by the spray method, reduction in the thickness of a part of the copper foil pattern 2 and the exposure of the copper foil pattern 2 can be prevented. Therefore, the copper foil pattern 2 can be protected from outside moisture, and corrosion can be prevented. In addition, edge portions of the copper foil pattern 2 can be protected.

As described above, by applying and forming the outline character forming layer 5 on the solder resist 3 coated and formed by the spray method, the copper foil pattern 2 other than a region overlapping with the character part is protected by two layers, i.e., the solder resist 3 and the outline character forming layer 5. Therefore, the copper foil pattern 2 can be more strongly protected from outside moisture than a case of being protected by a single layer, that is, the solder resist 3, and the corrosion can be more effectively prevented.

As described above, according to the present embodiment, the solder resist 3 is uniformly applied and formed by the spray method on the copper foil pattern 2 of the printed wiring board 1, and the outline character forming layer 5 is applied on the solder resist 3. With this process, most part of the copper foil pattern 2 is protected by two layers, i.e., the solder resist 3 and the outline character forming layer 5. Here, a region which is not protected by the two layers including the solder resist 3 and the outline character forming layer 5 includes a region of the character part of the outline character forming layer 5 and a region to be soldered. Therefore, corrosion of the copper foil pattern 2 caused by a change due to aging is effectively prevented, and the forming area of the coating layer 8 which has been formed on the entire surface to prevent the corrosion is reduced so that the degree of freedom in designing of the copper foil pattern 2 can be increased.

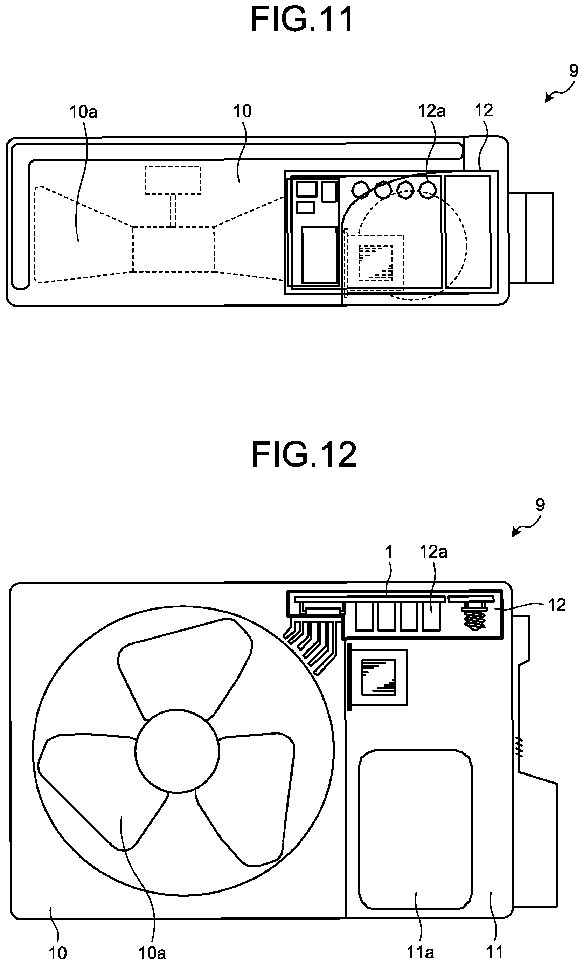

Next, an application example of the printed wiring board according to the present embodiment will be described. FIG. 11 is a schematic top view illustrating an outdoor unit of an air conditioner in which the printed wiring board according to the present embodiment has been arranged. FIG. 12 is a schematic front view illustrating the outdoor unit of the air conditioner in which the printed wiring board 1 according to the present embodiment has been arranged.

An outdoor unit 9 illustrated in FIGS. 11 and 12 includes a blower chamber 10 having a blower fan 10a, and a compressor chamber 11 having a compressor 11a and a flat electrical component box 12. The electrical component box 12 incorporates the printed wiring board 1 having a surface, on which electrical components 12a are mounted, facing downward and a surface, which has the copper foil, facing upward.

The electrical component box 12 storing the printed wiring board 1 is arranged above the compressor 11a of the compressor chamber 11. In the printed wiring board 1, it is possible to reduce the width the copper foil pattern which has been formed to be wide to prevent corrosion. Therefore, the printed wiring board 1 can be miniaturized. As a result, the electrical component box 12 can also be miniaturized, and the electrical component box 12 can be easily arranged above the compressor 11a. Furthermore, a cooling air passage can be easily secured.

Therefore, the electrical component box 12 in which the printed wiring board 1 is arranged can be formed in a flat shape in the height direction, and the electrical component box 12 of the compressor chamber 11 is formed in a flat shape so that an arrangement space can be reduced. Therefore, the degree of freedom of incorporating other component spaces is improved, and assembly work is facilitated. Furthermore, as described above, the corrosion of the printed wiring board 1 is prevented and the corrosion generated by a change due to aging is suppressed. Therefore, the quality of the air conditioner can be improved.

In the conventional printed wiring board, to prevent a change caused by aging due to the use environment so as not to cause the corrosion on the copper foil pattern, it has been necessary to apply and form the coating layer on the entire surface by the coating agent under the restriction in complicated design and manufacturing. However, according to the present embodiment described above, the corrosion of the copper foil pattern can be effectively prevented, and the restrictions in the design of the printed wiring board can be reduced. Furthermore, the restriction on the manufacturing is reduced. That is, in spite of simplification of the manufacturing process than a conventional one, it is possible to prevent the exposure of the copper foil pattern and to prevent the corrosion of the copper foil pattern. The reason why the manufacturing process can be simplified is because an application area of the coating layer can be reduced since it is not necessary to apply and form the coating layer on the entire printed wiring board and it is not necessary to apply and form the solder resist for a plurality of times.

As described above, by forming the solder resist by using the white ink and forming the outline character forming layer by using the green ink, the colors in the appearance of the printed wiring board is the same as those of the conventional printed wiring board. Therefore, it is possible to conduct a visual and conventional soldering state confirmation work during the conventional manufacturing process as before, and it is also possible to use the conventional color identification program of the appearance inspection device without any change. Therefore, it can be applied while suppressing changes to the conventional manufacturing process. A thermosetting ink is used for the ink, and it is preferable that the manufacturing process include a step of heating processing for curing the thermosetting ink.

The structures illustrated in the above embodiment indicate exemplary contents of the present invention and can be combined with other known technique. Furthermore, the structures illustrated in the embodiment can be partially omitted or changed without departing from the scope of the present invention.

### Reference Signs List

1 printed wiring board; 1a base material; 2 copper foil pattern; 3 solder resist; 4 character layer; 5 outline character forming layer; 6 surface mounting component; 7 solder; 8 coating layer; 9 outdoor unit; 10 blower chamber; 10a blower fan; 11 compressor chamber; 11a compressor; 12 electrical component box; 12a electrical component.

## Claims

1. A method of manufacturing a printed wiring board (1), comprising:
a step of forming a copper foil pattern (2) on a first main surface of a base material (1a);
a step of forming a solder resist (3) by uniformly spraying a first thermosetting ink which comprises a photosensitive component on the entire surface of the first main surface on which the copper foil pattern (2) is formed;
a step of temporary heating and drying the first thermosetting ink to be in a semi-cured state;
subsequently laminating an exposure film on the semi-cured first thermosetting ink, wherein the exposure film has a black and a transparent portion, irradiating the laminated film with ultraviolet rays and removing the semi-cured first thermosetting ink that was covered by the black portion during a development step, wherein the black portion corresponds to a portion that is to be soldered,
subsequently a step of printing an outline character forming layer (5) by using a second thermosetting ink on a region other than the portion that is to be soldered and a character forming portion, the character forming portion being a portion on which the characters are formed, and
subsequently a step of finally heating and drying the first thermosetting ink and the second thermosetting ink to be cured at a temperature higher than the temporary heating and drying.

2. The method of manufacturing a printed wiring board (1), according to claim 1, wherein the first thermosetting ink is formed by using a white ink, and the second thermosetting ink is formed by using a green ink.

## Patentansprüche

1. Verfahren zur Herstellung einer Leiterplatte (1), umfassend:
einen Schritt des Ausbildens eines Kupferfolienmusters (2) auf einer ersten Hauptoberfläche eines Basismaterials (1a);
einen Schritt des Ausbildens eines Lötstopplacks (3) durch gleichmäßiges Spritzen einer wärmehärtenden Farbe, die eine fotoempfindliche Komponente umfasst, auf die gesamte Oberfläche der ersten Hauptoberfläche, auf welcher das Kupferfolienmuster (2) ausgebildet ist;
einen Schritt des temporären Erwärmens und Trocknens der ersten wärmehärtenden Farbe, damit diese in einem halbgehärteten Zustand ist;
nachfolgend Laminieren eines Expositionsfilms auf der halbgehärteten ersten wärmehärtenden Farbe, wobei der Expositionsfilm einen schwarzen und einen transparenten Abschnitt aufweist, Bestrahlen des laminierten Films mit ultravioletten Strahlen und Entfernen der halbgehärteten ersten wärmehärtenden Farbe, die während eines Entwicklungsschrittes durch den schwarzen Abschnitt bedeckt wurde, wobei der schwarze Abschnitt mit einem Abschnitt korrespondiert, der zu löten ist,
nachfolgend einen Schritt des Druckens einer umrisszeichenbildenden Schicht (5) durch Verwenden einer zweiten wärmehärtenden Farbe auf einer anderen Region als dem Abschnitt, der zu löten ist, und einem zeichenbildenden Abschnitt, wobei der zeichenbildende Abschnitt ein Abschnitt ist, auf dem die Zeichen ausgebildet werden, und
nachfolgend einen Schritt des abschließenden Erwärmens und Trocknens der ersten wärmehärtenden Farbe und der zweiten wärmehärtenden Farbe, zu härten bei einer Temperatur, die höher als das temporäre Erwärmen und Trocknen ist.

2. Verfahren zur Herstellung einer Leiterplatte (1) gemäß Anspruch 1, wobei die erste wärmehärtende Farbe durch Verwendung einer weißen Farbe ausgebildet wird, und die zweite wärmehärtende Farbe wird durch Verwendung einer grünen Farbe ausgebildet.

## Revendications

1. Procédé de fabrication d'une carte de circuit imprimé (1), comprenant :
une étape de formation d'un motif de feuille de cuivre (2) sur une première surface principale d'un matériau de base (la) ;
une étape de formation d'une réserve de soudure (3) en pulvérisant uniformément une première encre thermodurcissable qui comprend un composant photosensible sur la surface entière de la première surface principale sur laquelle le motif de feuille de cuivre (2) est formé ;
une étape de chauffage et de séchage temporaires de la première encre thermodurcissable afin qu'elle se trouve dans un état semi-durci ;
la stratification d'un film d'exposition sur la première encre thermodurcissable semi-durcie, dans lequel le film d'exposition possède une partie noire et une partie transparente, en irradiant le film stratifié avec des rayons ultraviolets et en retirant la première encre thermodurcissable semi-durcie qui a été recouverte par la partie noire pendant une étape de développement, dans lequel la partie noire correspond à une partie qui doit être soudée,
une étape ultérieure d'impression d'une couche de formation de caractère de contour (5) à l'aide d'une seconde encre thermodurcissable sur une zone autre que la partie qui doit être soudée et une partie de formation de caractères, la partie de formation de caractères étant une partie sur laquelle les caractères sont formés, et
une étape ultérieure de chauffage et de séchage finaux de la première encre thermodurcissable et de la seconde encre thermodurcissable afin qu'elles soient durcies à une température supérieure à la température de chauffage et de séchage temporaires.

2. Procédé de fabrication d'une carte de circuit imprimé (1) selon la revendication 1, dans lequel la première encre thermodurcissable est formée à l'aide d'une encre blanche, et la seconde encre thermodurcissable est formée à l'aide d'une encre verte.
